# EUROPÄISCHE PATENTSCHRIFT

(11) **EP 0 542 684 B1**
(45) Veröffentlichungstag und Bekanntmachung des Hinweises auf die Patenterteilung: **09.04.1997**
(21) Anmeldenummer: 92810852.1
(22) Anmeldetag: 04.11.1992
(51) Int. Cl.: B05C 5/00, B05C 13/02, H05K 13/00

(54) **Beschichtungsvorrichtung für Platten**
Coating device for plates
Dispositif de revêtement de plaques

(30) Priorität: 13.11.1991 EP 91810879
(43) Veröffentlichungstag der Anmeldung: 19.05.1993
(73) Patentinhaber: CIBA-GEIGY AG, 4002 Basel (CH)
(72) Erfinder: Kuster, Kaspar, CH-4057 Basel (CH)

(56) Entgegenhaltungen:
- EP-A- 0 393 796
- EP-A- 0 441 743
- TECHNICAL DIGEST - WESTERN ELECTRIC Nr. 44, Oktober 1976, Seiten 11 - 12 P.W. BYRD, W.D. TIPPETT 'transfer mechanism for processing printed wiring boards'

## Beschreibung

Die Erfindung betrifft eine Beschichtungsvorrichtung gemäss dem Oberbegriff des unabhängigen Patentanspruchs.

Beschichtungsvorrichtungen für Platten oder plattenförmige Werkstücke sind in verschiedenen Ausführungsformen bekannt und sind insbesondere bei der Beschichtung von Leiterplatten (z.B. mit Lötstopplack etc.) im Einsatz. Eine solche Beschichtungsvorrichtung und ihre prinzipielle Funktionsweise ist beispielsweiese in der EP-A-145,648 beschrieben. Dabei wird die zu beschichtende Platte unter einem Giessvorhang, der aus einem Vorhanggieskopf herabfällt, hindurch transportiert. Der Giesskopf ist dabei so angeordnet, dass der herabfallende Giessvorhang die Platte längs einer quer zur Transportrichtung der Platte verlaufenden Auftrefflinie beaufschlagt. Durch den kontinuierlichen Weitertransport der Platte unter dem Giessvorhang hindurch wird die Platte auf diese Art und Weise beschichtet.

Weiterhin ist aus der EP-A-312,498 eine Transportvorrichtung für solche zu beschichtenden Leiterplatten bekannt. Dort werden die zu beschichtenden Platten in einer Zuführstation zunächst mit Hilfe von rechenartigen Ausrichtmitteln so ausgerichtet, dass die Plattenkanten nach dem Ausrichten etwa parallel zur Transportrichtung der Platte angeordnet sind. Die so ausgerichtete Platte wird mit Hilfe von ersten Transportmitteln, die hier als Zuführrollenbahn ausgebildet sind, einer Vorhangbeschichtungseinrichtung der oben beschriebenen Art zugeführt. Dabei sind in dieser Vorhangbeschichtungseinrichtung zweite Transportmittel vorgesehen, die die zu beschichtenden Platten dann unter dem Giessvorhang hindurch führen, sobald die jeweilige zu beschichtende Platte vollständig in die Beschichtungseinrichtung eingelaufen ist.

Der Umstand, dass zwei Transportmittel vorgesehen sind, ist dadurch bedingt, dass die Platten mit einer höheren Geschwindigkeit unter dem Giessvorhang durchgeführt werden müssen, als sie von der Zuführstation aus in die Vorhangbeschichtungseinrichtung einlaufen. Dabei hängt die Geschwindigkeit, mit der die Platten unter dem Giessvorhang durchgeführt werden, von mehreren Faktoren, insbesondere aber von der Art der Beschichtungsmasse (z.B. Lack) und von der Fallhöhe des Vorhangs ab. Durch die Tatsache, dass die Transportgeschwindigkeit in der Vorhangbeschichtungseinrichtung höher ist als die Zuführgeschwindigkeit, ist auch gewährleistet, dass ein gewisser zeitlicher Puffer zwischen zwei aufeinander folgenden zugeführten Platten besteht.

Die beschriebenen Vorrichtungen sind an sich funktionstüchtige Geräte, haben aber noch Mängel. So ist es bei den beschriebenen Geräten beispielsweise erforderlich, die Platten in zwei voneinander getrennten Arbeitsgängen auszurichten und die ausgerichteten Platten an die Vorhangbeschichtungseinrichtung zu übergeben. Dies ist zum einen aufwendig, d.h. es erfordert zwei gesonderte Einrichtungen, nämlich einerseits Ausrichtmittel (z.B. der oben beschriebene Rechen) und andererseits Mittel zum Übergeben der Platten an die zweiten Transportmittel. Zum anderen erfordern solche Mittel auch einigen Platz, der im Zeitalter fortschreitender Verkleinerung in zunehmendem Masse knapp (und obendrein auch teuer) wird.

Weitere Nachteile bereits existierender Geräte liegen ausserdem auch darin, dass die Platten in der Vorhangbeschichtungseinrichtung auf Transportbändern aufliegen und auf diesen aufliegend durch den Giessvorhang hindurch transportiert werden, wodurch die Qualität der Auflagefläche beeinträchtigt werden kann. Dadurch können Schwierigkeiten bei dem Transport der Platte durch den Vorhang auftreten. Die Transportbänder reichen nämlich zu beiden Seiten des Vorhangs nur bis kurz vor den Vorhang heran, so dass der herabfallende Vorhang beim Beschichten nicht auf die Transportbänder fallen kann. Ist die zu beschichtende Platte nicht ganz eben, so kann es beim Übergang der Platte von dem einen Band, das bis kurz vor den Vorhang reicht, auf das kurz nach dem Vorhang beginnende Band wegen der Unebenheit der Platte zu Schwierigkeiten kommen. Ausserdem können die Transportbänder immer noch vergleichsweise einfach verschmutzen, z.B. dann, wenn die vorlaufende Plattenkante den Giessvorhang durchstösst und Beschichtungsmasse von der Kante auf das Transportband "gestossen" wird oder durch Bohrlöcher in einer Platine auf das Transportband gelangt.

Es ist daher eine Aufgabe der Erfindung, eine Beschichtungsvorrichtung vorzuschlagen, die einerseits den Platzverbrauch solcher Vorrichtungen minimiert, andererseits ein sicheres Ausrichten und Übergeben der Platten an die Vorhangbeschichtungseinrichtung bzw. an die darin vorgesehenen zweiten Transportmittel ermöglicht. Zusätzlich ist es wünschenswert, wen die Platte möglichst ohne weitere Übergaben während des Beschichtungsvorgangs und ausserdem möglichst ruckfrei durch den Giessvorhang transportiert wird und wenn ausserdem Verschmutzungen der Transportmittel weitestgehend vermieden werden.

Diese Aufgabe wird durch die Merkmale des Patentanspruchs 1 gelöst. Beim Ausrichten der Platten übergeben die Ausrichtmittel die Platten von den ersten Transportmitteln an die zweiten Transportmittel. Auf diese Weise werden zwei Arbeitsschritte gemeinsam durchgeführt, so dass der Platzverbrauch deutlich geringer ist als bei bekannten Vorrichtungen. Gleichzeitig wird die zu beschichtende Platte sicher an die zweiten Transportmittel übergeben, welche die Platte durch den Giessvorhang führen. Die Ausrichtmittel umfassen zwei etwa parallel zur Transportrichtung der Platten seitlich angeordnete Richtorgane. Diese Richtorgane sind im wesentlichen senkrecht zur Transportrichtung aufeinander zu bzw. voneinader weg bewegbar und richten bei ihrer Bewegung aufeinander zu die Platte an den Plattenkanten aus. Die Richtorgane sind dabei mit Übergabemitteln gekoppelt, die jeweils eine schiefe Ebene definieren. Diese schiefe Ebene erstreckt sich im wesentlichen zwischen einer durch die ersten Transportmittel definierten ersten Transportebene und einer durch die zweiten Transportmittel definierten zweiten Transportebene. Die zweite Transportebene verläuft dabei im wesentlichen parallel Zur ersten Transportebene und oberhalb von ihr. Die Übergabemittel heben die Platten von den ersten Transportmittein ab, und übergeben sie über die schiefe Ebene hinweg an die zweiten Transportmittel. Zum einen ist auf diese Weise der Übergabevorgang einfach und sicher. Zum anderen sind die Transportgeschwindigkeiten der ersten und der zweiten Transportmittel in der Regel unterschiedlich, d.h. die Transportgeschwindigkeit der zweiten Transportmittel, die die zu beschichtende Platte durch den Giessvorhang führen, ist höher. Durch die Entkoppelung auf zwei unterschiedliche Transportebenen und die sichere Übergabe der Platte bereitet die Übergabe von einem Transportmittel auf das andere keinerlei Schwierigkeiten.

In einer Ausgestaltung der Erfindung sind die Richtorgane symmetrisch aufeinander zu bzw. voneinander weg bewegbar.

In einer weiteren Ausgestaltung der Erfindung umfassen die Übergabemittel freilaufende konische Rollen, die in dem Bereich, in dem die von den ersten Transportmitteln kommenden Platten zwischen die Richtorgane einlaufen, angeordnet sind. Dabei sind sie derart entlang der Richtorgane angeordnet, dass sich die Rollenachsen parallel zur Bewegungsrichtung der Richtorgane erstrecken, so das die Richtorgane durch ihre Bewegung aufeinander zu die Platten über die konischen Rollen (schiefe Ebene) hinweg bewegen und an die zweiten Transportmittel übergeben.

In einer Ausführungsvariante der Erfindung umfassen die Richtorgane Richtholme und die zweiten Transportmittel antreibbare Transportbänder. Die Transportbänder sind in Transportrichtung um den jeweiligen Richtholm herumlaufend angeordnet, wobei die Ebene des jeweiligen Transportbands im wesentlichen senkrecht zur Transportebene der Platte verläuft, d.h. die Transportbänder greifen beim Plattentransport an den Seitenkanten der Platten an. In einer einfachen Weise können dabei die Transportbänder eine Längsnut aufweisen, in der das jeweilige Transportband an der zugehörigen Seitenkante der Platte angreift. Die Kraft, mit der die Transportbänder an den Seitenkanten der Platten angreifen ist in einer vorteilhatten Ausgestaltung dabei einstellbar, beispielsweise mittels einer einstellbaren Hydraulik/Pneumatik.

Eine weitere Ausgestaltung der Erfindung zeichnet sich dadurch aus, dass mit den Richtorganen Begrenzungsorgane zur seitlichen Begrenzung des Giessvorhangs gekoppelt sind, welche gemeinsam mit den Richtorganen verstellbar sind. Dadurch wird die effektive Breite des Giessvorhangs, durch den die Platte geführt ist, gleichzeitig mit der Ausrichtung und dem Transport der Platte an die Breite der zu beschichtenden Platte angepasst. Dabei sind in vorteilhafter Weise die Begrenzungsorgane zur seitlichen Begrenzung des Giessvorhangs so angeordnet, dass der herabfallende Giessvorhang die Platten in einem schmalen Randbereich nahe der Seitenkante der Platte, an der ja die Transportbänder angreifen, nicht beaufschlagt. Dadurch können die Platten im weiteren auf ihren Seitenrändem aufliegend weitertransportiert werden, ohne dass selbst bei beidseitig beschichteten Platten Beschädigungen der Beschichtungsmasse bzw. des Lacks auftreten können. Beispielsweise können sie auf einer V-förmigen Rollenbahn weitertransportiert werden. Ausserdem bleiben bei dieser Art des Transports die Tranportbänder frei von Verschmutzung durch Beschichtungsmasse. Die Begrenzugsorgane können durch an sich bekannte Giessmesser gebildet sein, die an den Richtorganen befestigt sind.

In einer weiteren Ausgestaltung der Erfindung sind die Begrenzungsorgane (Giessmesser) zur seitlichen Begrenzung des Giessvorhangs so angeordnet, dass der herabfallende Giessvorhang die Platte vollständig über deren gesamte Breite beaufschlagt. Dies kann beispielsweise so realisiert sein, dass im Bereich des herabfallenden Giessvorhangs eine Umlenkeinrichtung angeordnet ist, welche die Transportbänder in Transportrichtung betrachtet eine kurze Strecke vor dem Giessvorhang von den Seitenkanten der Platte nach aussen weg um die Umlenkeinrichtung herum führt. Eine kurze Strecke nach dem Giessvorhang werden sie dann wieder zu den Seitenkanten der Platte hin geführt.

In einer weiteren Ausgestaltung der Erfindung umfassen die zweiten Transportmittel ein Stützband, welches in Transportrichtung etwa in der von den zweiten Transportmitteln definierten zweiten Transportebene angeordnet ist. Dieses Stützband verläuft so, dass grössere Platten, die sich in der Mitte durchbiegen, durch dieses zusätzliche Band gestützt werden. Die Richtorgane sind dabei symmetrisch in Bezug auf dieses Transportband aufeinander zu bzw. voneinander weg verstellbar.

Im folgenden wird die Erfindung anhand der Zeichnung näher erläutert Es zeigen in teilweise schematischer Darstellung:
- Fig. 1: eine Aufsicht aufein Ausführungsbeispiel der erfindungsgemässen Beschichtungsvorrichtung,
- Fig. 2: einen Schnitt gemäss der Linie II-II der Fig. 1,
- Fig. 3: eine Detaildarstellung eines Ausschnitts III der Übergabe- und der zweiten Transportmittel der Fig. 2,
- Fig. 4: eine Detaildarstellung der Vorhangbeschichtungseinrichtung der erfindungsgemässen Beschichtungsvorrichtung,
- Fig. 5: ein anderes Ausführungsbeispiel der Vorhangbeschichtungseinrichtung mit einer Umlenkeinrichtung im Bereich des Giessvorhangs
- Fig. 6: einen Schnitt entlang der Linie VI-VI der Fig. 5
- Fig. 7: die Umlenkeinrichtung der Fig. 5
- Fig. 8: ein weiteres Ausführungsbeispiel der Vorhangbeschichtungseinrichtung der erfindungsgemässen Beschichtungsvorrichtung,
und
- Fig. 9: ein Detail IX der Fig. 8

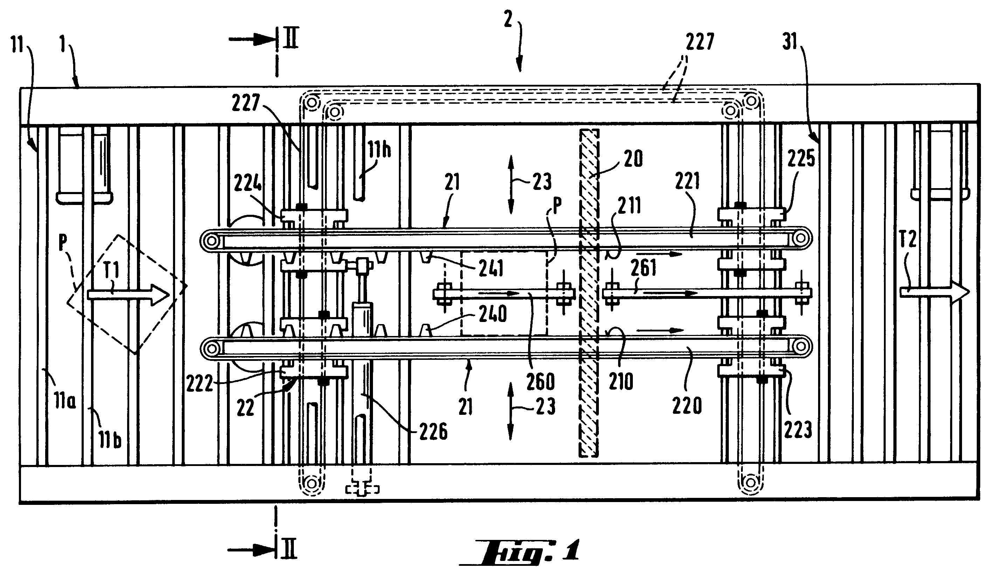

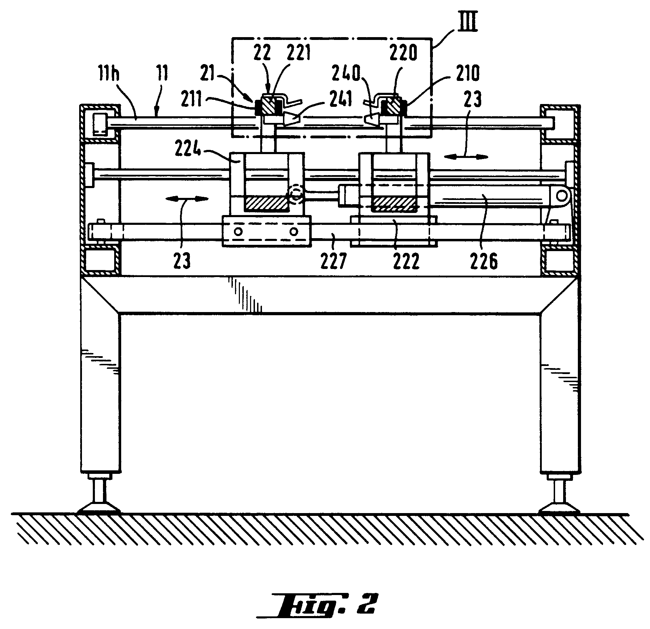

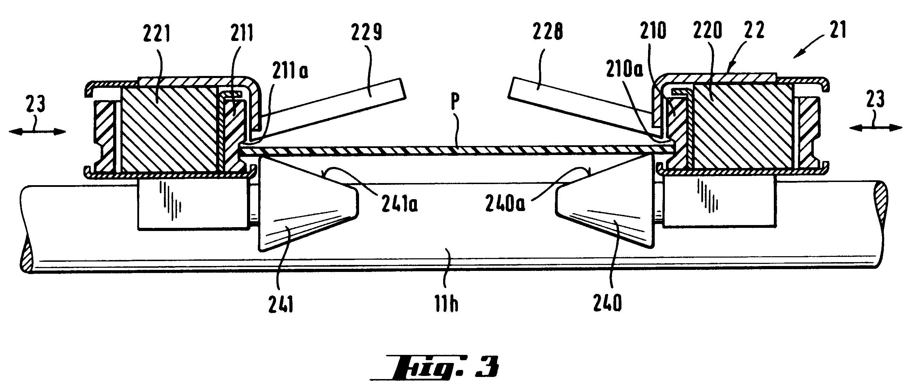

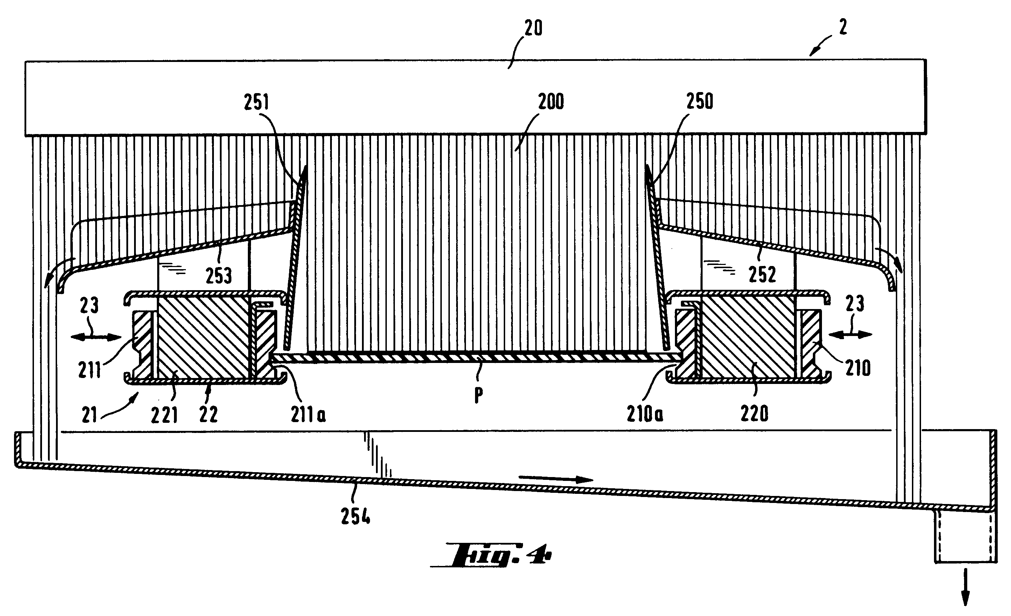

Das in Fig. 1 gezeigte Ausführungsbeispiel der erfindungsgemässen Beschichtungsvorrichtung umfasst erste Transportmittel 1, hier in Form der Rollenbahn 11, von der nur die Rollen 11a und 11b mit Bezugszeichen versehen sind. Diese ersten Transportmittel transportieren eine in Fig. 1 strichliert dargestellte zu beschichtende Platte P in Richtung des Pfeils T1 zu einer Vorhangbeschichtungseinrichtung 2. Die Vorhangbeschichtungseinrichtung 2 umfasst einen strichliert angedeuteten Vorhanggiesskopf 20, zweite Transportmittel 21, die im Detail in Fig. 3 dargestellt sind, und Ausrichtmittel 22, welche die Platte P an ihren Kanten etwa parallel zur Transportrichtung ausrichten. Die zweiten Transportmittel 21 transportieren die ausgerichtete Platte P, beispielsweise eine Leiterplatte, durch einen von dem Vorhanggiesskopf 20 herabfallenden Giessvorhang 200 (Fig. 4) hindurch. Die auf diese Weise beschichtete Platte P kann dann in Richtung des Pfeils T2, beispielsweise auf einer Rollenbahn 31, zu einer Trocknungseinrichtung (nicht dargestellt) geführt werden.

In einem groben Überblick funktioniert die Beschichtungsvorrichtung wie folgt: Eine zu beschichtende Leiterplatte P, die beispielsweise mit einem UV-härtbaren Lötstopplack beschichtet werden soll, wird auf der Rollenbahn 11, deren Rollen antreibbar sind, in Richtung des Pfeils T1 zugeführt Dabei kann die Leiterplatte schief auf der Rollenbahn 11 aufliegen, wie dies in Fig. 1 angedeutet ist Erreicht die Leiterplatte P die Vorhangbeschichtungseinrichtung 2, so werden die Ausrichtmittel 22 von ihrer Ausgangsstellung (ganz aussen), die ans zeichnerischen Gründen nicht dargestellt ist, gemäss den Pfeilen 23 nach innen bewegt. Die Ausrichtmittel 22 umfassen dabei im wesentlichen zwei als Richtholme 220 und 221 ausgebildete Richtorgane, welche die Kanten der Platte P etwa parallel zur Transportrichtung ausrichten. Dieses Ausrichten der Plattenkanten erfolgt durch die Bewegung der beiden Richtholme 220 und 221 aufeinander zu, d.h. die Richtholme 220 und 221 sind etwa senkrecht zur Transportrichtung der Platte P aufeinander zu bewegbar. In dieser zusammengefahrenen Stellung sind die Richtholme 220 und 221 in der Fig. 1 erkennbar. Gleichzeitig mit dem Ausrichten der Platte P wird diese von der Rollenbahn 11 nach oben abgehoben und an die zweiten Transportmittel 21 übergeben. Wie dieser Übergabevorgang im Detail erfolgt, wird anhand Fig. 2 und Fig. 3 noch genauer erläutert werden. Die Platte P wird alsdann in der Vorhangbeschichtungseinrichtung 2 beschichtet. Hat die beschichtete Platte P dann die Beschichtungseinrichtung verlassen und befindet sich auf der Rollenbahn 31, so werden die Richtholme 220 und 221 wieder in Richtung der Pfeile 23 voneinander weg bewegt, also in ihre Ausgangsstellung zurück.

Anhand von Fig. 2 und Fig. 3 soll nun der Ausricht- und der Übergabevorgang einer Platte P von den ersten Transportmitteln, also von der Rollenbahn 11, an die zweiten Transportmittel 21 erläutert werden. Diese Übergabe der Platte P erfolgt, wie bereits oben erwähnt, gleichzeitig mit ihrem Ausrichten. Zu diesem Zweck werden die Richtholme 220 und 221, die jeweils mit zwei Schlitten 222 und 223 bzw. 224 und 225 verbunden sind, aufeinander zu bewegt. In vorteilhafter Weise erfolgt diese Verstellung der Richtholme 220 und 221 symmetrisch, d.h. die Richtholme 220 und 221 werden symmetrisch aus ihrer Ausgangsstellung aufeinander zu (und später wieder voneinander weg) bewegt. Eine Möglichkeit der Realisierung einer solchen symmetrischen Verstellung der Richtholme 220 und 221 kann man bei gleichzeitiger Betrachtung von Fig. 1 und Fig. 2 erkennen. Zu diesem Zweck ist eine Hydraulik oder eine Pneumatik 226 vorgesehen, welche einen der Schlitten, z.B. den Schlitten 224, und mit ihm den Richtholm 221, aus der Ausgangsstellung (also ganz aussen) nach innen, also auf den anderen Richtholm 220 zu bewegt. Da die Schlitten 222, 223, 224 und 225 alle mit einem umlaufenden Riemen 227 fest in der in Fig. 1 gezeigten Weise verbunden sind, werden durch die Verstellung eines Schlittens, z.B. des Schlittens 224, alle Schlitten symmetrisch verstellt.

In Fig. 3 ist der Ausschnitt III der Fig. 2 noch einmal vergrössert dargestellt. Mit Hilfe dieses Ausschnitts ist besonders gut erkennbar, wie die Übergabe der Platte P von der Rollenbahn 11 (Fig. 1) zu den zweiten Transportmitteln 21 erfolgt. Dazu ist die Rolle 11h erkennbar, die die Rollenbahn 11 repräsentiert. Auf dieser Rollenbahn 11 werden die zu beschichtenden Platten P zugeführt. Erreicht die Platte P die Vorhangbeschichtungseinrichtung 2, dies kann z.B. mittels eines Detektors (nicht dargestellt) festgestellt werden, der die Platte detektiert, so werden die beiden Richtholme 220 und 221 in der oben bereits erläuterten Art und Weise in Richtung der Pfeile 23 aufeinander zu bewegt. In dem Bereich, in dem die von der Rollenbahn 11 kommenden Platten P zwischen die Richtholme 220 und 221 einlaufen, sind konische Rollen entlang der Richtholme angeordnet, von denen in Fig. 3 nur die zwei konischen Rollen 240 und 241 dargestellt sind. Die Rollenachsen erstrecken sich dabei parallel zur Bewegungsrichtung 23 der Richtholme 220 und 221. Durch die Rollenbahn 11 (Fig. 1) ist eine erste Transportebene definiert, in der die Platten P zugeführt werden. Werden nun die Richtholme aufeinander zu bewegt, so wird die Platte P über die Mantelflächen 240a bzw. 241a hinweg bewegt und so von dieser ersten Transportebene abgehoben. Die weitere Bewegung der Richtholme 220 und 221 aufeinander zu bewirkt, dass die Platte P weiter über die Mantelflächen 240a und 241a der konischen Rollen 240 und 241 bewegt wird, bis sie in eine Längsnut 210a bzw. 211a der Transprotbänder 210 bzw. 211 hineinrutschen. Damit die Platte P nicht nach oben "ausbrechen" kann, können Rückhaltebügel 228 und 229 vorgesehen sein. Die Transportbänder 210 und 211 laufen um den jeweiligen Richtholm 220 und 221 herum in Längsrichtung um. Die Ebene des jeweiligen Transportbands 210 bzw. 211 verläuft dabei im wesentlichen senkrecht zur Transportebene der Platte. Erreicht also die Platte P die Transportbänder 210 bzw. 211, durch deren Verlauf eine zweite Transportebene definiert ist, so ist durch diesen Übergabevorgang quasi die Platte P von einer ersten Transportebene (Rollenbahn) über eine schiefe Ebene (Mantelfläche der konischen Rollen) hinweg auf eine zweite Transportebene (Transportbänder) übergeben worden, die oberhalb der ersten Transportebene und parallel zu dieser verläuft. Dieses Abheben von der Rollenbahn 11 und das Übergeben an die Transportbänder 210 und 211 ist sehr Von Vorteil, da die Platten mit einer deutlich höheren Geschwindigkeit durch den Giessvorhang 200 (Fig. 4) hindurch bewegt werden, als sie über die Rollenbahn 11 zugeführt werden. Dadurch können die Antriebe dieser beiden Transportmittel voneinander entkoppelt arbeiten; ausserdem ist so ein gewisser zeitlicher "Puffer" zwischen zwei auf der Rollenbahn 11 aufeinanderfolgende Platten P gewährleistet. Die Kraft, mit der die Transportbänder an den Kanten der Platte P angreifen, kann mit Hilfe der Hydraulik bzw. Pneumatik 226 einstellbar sein und so dem jeweiligen Plattenmaterial angepasst werden.

Ist die Platte P in die Längsnuten 210a und 211a der Transportbänder 210 und 211 hineingerutscht und greifen diese mit der eingestellten Kraft an den Plattenkanten an, beginnt der eigentliche Beschichtungsvorgang. Dazu wird die Platte durch den Giessvorhang 200 hindurchbewegt, der aus dem Vorhanggiesskopf 20 herabfällt, wie es in Fig. 4 dargestellt ist. Mit den Richtholmen 220 und 221 sind Begrenzugsorgane verbunden, die als Giessmesser 250 und 251 konventioneller Art ausgebildet sein können. Derartige Giessmesser sowie das prinzipielle Verfahren der Vorhangbeschichtung sind beispielsweise in der EP-A-145 648 beschrieben. Diese Begrenzugsorgane (Giessmesser) dienen dazu, die effektive Breite des Giessvorhangs 200 zu begrenzen, der die zu beschichtende Platte P beaufschlagt. Wie aus Fig. 4 erkennbar ist, sind bei dem beschriebenen Ausführungsbeispiel diese Giessmesser 250 und 251 fest mit den Richtholmen 220 und 221 verbunden, so dass bei einer Bewegung der Richtholme 220 und 221 stets auch die Giessmesser 250 und 251 entsprechend mitbewegt werden. Dies ist besonders von Vorteil, da auf diese Weise die effektive Breite des Giessvorhangs 200 gleichzeitig mit der Verstellung der Richtholme 220 und 221 so erfolgt, dass die effektive Vorhangbreite an die Breite der von den Transportbändern 210 und 211 transportierten Platte P angepasst ist. Man erkennt aus Fig. 4, dass die Giessmesser 250 und 251 so an den Richtholmen befestigt sind, dass der Giessvorhang 200 die zu beschichtende Platte P über deren gesamte Breite beaufschlagt abgesehen von einem schmalen Randbereich nahe den Seitenkanten der Platte P. Diese Festlegung der effektiven Vorhangbreite ist vorteilhaft, weil auf diese Weise die Transportbändern 210 und 211 gänzlich vor der herabfallenden Beschichtungsmasse (z.B. Lack) geschützt sind und unverschmutzt bleiben, d.h. einerseits bleiben die Plattenkanten und Plattenränder unbeschichtet, andererseits müssen die Transportbänder 210 und 211 nicht ständig gereinigt werden. Dadurch wird der Reinigungsaufwand für die Transportbänder sowie der damit verbundene Aufwand für den Ein- und Ausbau der Bänder vermieden. Der Rest des Giessvorhangs 200, der ausserhalb der effektiven Vorhangbreite herabfällt, welche von den Giessmessern 250 und 251 begrenzt ist, wird über Ableitbleche 252 und 253 einer Auffangwanne 254 zugeführt.

Nachdem die Platte P in der beschriebenen Weise beschichtet ist, kann sie beispielsweise auf die Rollenbahn 31 (Fig. 1) übergeben und in Richtung des Pfeils T2 beispielsweise an eine Trocknungseinrichtung (nicht dargestellt) übergeben werden. Die Richtholme 220 und 221 werden dann in Richtung der Pfeile 23 in ihre Ausgangsstellung (nach aussen) zurückbewegt und die nächste Platte P kann in gleicher Weise von der Rollenbahn 11 einlaufen und in der beschriebenen Weise an die Transportbänder 210 und 211 (Fig. 3) übergeben werden.

Als zusätzliche Weiterbildung kann die erfindungsgemässe Beschichtungsvorrichtung bzw. deren zweite Transportmittel 21 noch ein weiteres Transportband bzw. zwei weitere Transportbänder 260 und 261 umfassen, die in Fig. 1 angedeutet sind. Diese Transportbänder 260 und 261 sind etwa in der zweiten Transportebene angeordnet, die von den seitlichen Transportbändern 210 bzw. 211 (bzw. von deren Längsnuten 210a und 211a) definiert werden und verlaufen in Transportrichtung der Platte. Sie dienen dazu, Planen grösserer Breite, die durch ihr Eigengewicht in der Mitte zum Durchhängen neigen, zu unterstützen, so dass beim Durchführen der Platte P durch den Vorhang kein "Wanneneffekt" auftritt und der gesamte Lack in die Plattenmitte läuft. Selbstverständlich entspricht dabei die Geschwindigkeit, mit der diese Bänder 260 und 261 umlaufen, der Transportgeschwindigkeit, mit der die Transportbänder 210 und 211 die Platte P durch den Giessvorhang 200 hindurch bewegen. Bei dieser Weiterbildung sind die Richtholme 220 und 221 symmetrisch in Bezug auf diese weiteren Transportbänder 260 und 261 verstellbar, damit auch die Plattenmitte durch die zusätzlichen Bänder 260 und 261 unterstützt wird.

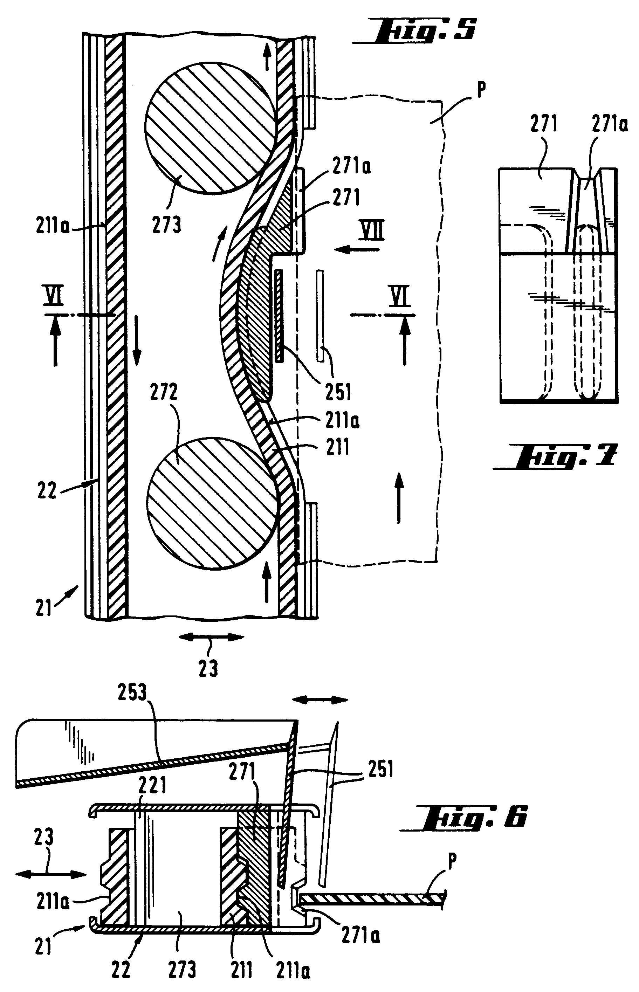

Ein weiteres Ausführungsbeispiel der Vorhangbeschichtungseinrichtung 2 ist in Fig. 5 dargestellt. Aus Symmetriegründen ist hier nur ein Transportband 211 dargestellt. In dieser Figur ist erkennbar, dass das Transportband 211 in Transportrichtung betrachtet kurz vor dem Giessvorhang (er fällt dort herab, wo das Giessmesser 251 angedeutet ist) von der Seitenkante der Platte P nach aussen weg geführt ist. Dies erfolgt mit Hilfe einer Umlenkeinrichtung 271, die das Transportband 211 kurz nach dem Giessvorhang wieder zur Seitenkante der Platte P hin führt. Damit das Tansportband 211 gespannt bleibt und erst kurz vor dem Giessvorhang die Seitenkante der Platte P nur für die kurze Strecke unter dem Giessvorhang hindurch freigibt, ist kurz vor der Umlenkeinrichtung 271 noch eine Führungsrolle oder Führungswalze 272 vorgesehen. Der Umlenkeinrichtung 271 nachfolgend ist entsprechend eine weitere Führungswalze 273 vorgesehen, so dass das Transportband 211 kurz nach dem Giessvorhang wieder an der Seitenkante der Platte P angreift.

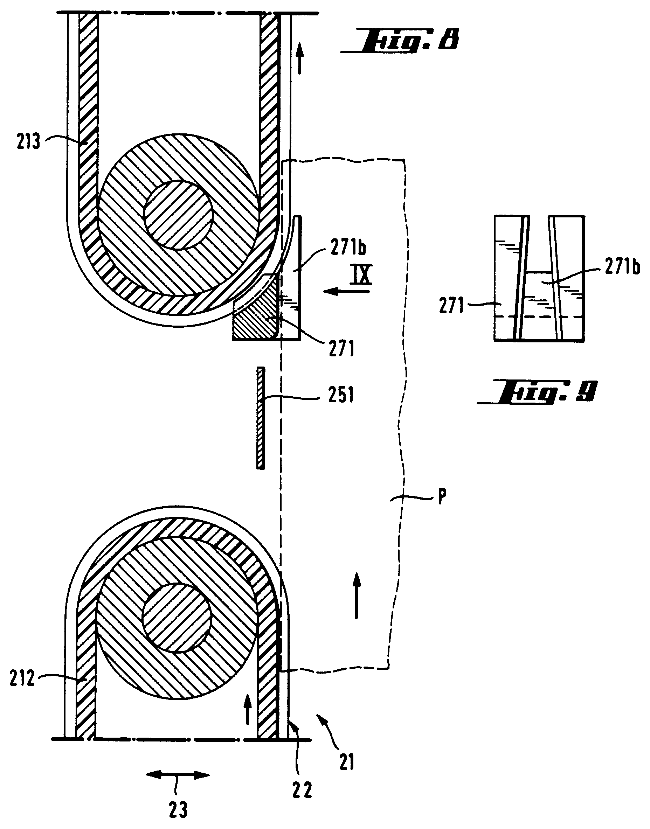

Auf diese Weise kann erreicht werden, dass der herabfallende Giessvorhang die Platte P vollständig über deren gesamte Breite beaufschlagt, ohne dass der Rand der Platte unbeschichtet bleibt und ohne dass die Transportbänder beschmutzt werden. Der Schnitt entlang der Linie VI-VI in Fig. 5 , der in Fig. 6 dargestellt ist, verdeutlicht dies. Dort ist die Position des Giessmessers 251 in der Position, in der der Seitenrand der Platte P nicht beschichtet wird, mit schwachen Linien angedeutet und mit starken Linien die Position, in welcher die Platte P über ihre gesamte Breite beschichtet wird. Zur Führung der Platte P in die Nut 211a des Transportbands 211 hinein ist eine entsprechende konisch zulaufade Führung 271a an der Umlenkeinrichtung 271 vorgesehen, wie aus Fig. 7 gut ersichtlich ist.

In Fig. 8 ist ein weiteres Ausführungsbeispiel der Vorhangbeschichtungseinrichtung 2 (Fig. 1) dargestellt. Dort sind zwei getrennte Transportbänder, ein ankommendes 212 und ein wegführendes 213, anstelle eines durchgehenden Transportbands 211 vorgesehen. Dadurch ist eine Umlenkung des Transportbands im Bereich des Giessvorhang nicht erforderlich und trotzdem kann die Platte P über ihre gesamte Breite hinweg beschichtet werden. Die Platte P wird auch hier kurz vor dem Erreichen des Giessvorhangs (in Fig. 8 ist zu diesem Zweck die Position des Giessmessers 251 angedeutet) an ihrer Seitenkante vom, ankommenden Transportband 212 freigegeben und kurz nach dem Giessvorhang von dem wegführenden Transportband 213 wieder angegriffen. Zum Einführen der Platte P in die Nut des wegführenden Transportbands 213 ist bei diesem Ausführungbeispiel eine konisch zulaufende Führung 271b vorgesehen, wie sie in Fig. 9 noch einmal deutlicher dargestellt ist. Bei diesem Ausführungsbeispiel ist es erforderlich, dass die Geschwindigkeit der beiden Transportbänder 212 und 213 übereinstimmt. Sie können 'zu diesem Zweck beispielsweise synchronisiert angetrieben sein.

Besonders geeignet ist die erfindungsgemässe Beschichtungsvorrichtung für die Beschichtung von Leiterplatten mit mit UV-härtbarem Kunststoff oder Lacken aller Art, z.B. mit Lötstopplack. Selbstverständlich sind aber auch andere Arten von Beschichtungsmassen möglich. Die Vorrichtung ist besonders kompakt, ermöglicht also insbesondere eine Platzersparnis im Vergleich zu bekannten Vorrichtungen, was im Zeitalter des zunehmenden Platzmangels von besonderem Vorteil ist. Ausserdem werden bei der erfindungsgemässen Vorrichtung mehrere Arbeitsschritte (Ausrichten, Ausmessen und Übergeben der Platten) in einem Arbeitsschritt durchgeführt, was neben der räumlichen Einsparung auch noch einen Zeitvorteil bedeuten kann. Weiterhin liegen die zu beschichtenden Platten bei der Beschichtung nicht wie bei bekannten Vorrichtungen auf Transportbändern auf, so dass die Qualität der Auflagefläche nicht beeinträchtigt werden kann bzw. Beschädigungen dieser Auflagefläche vermieden werden können. Dies ist inbesondere dann von grossem Vorteil, wenn die Platten nach der Beschichtung der einen Plattenfläche, nach einer anschliessenden Trocknung und nach einem Wenden der Platte auf der anderen Plattenseite, die vorher die Auflagefläche gebildet hätte, auch noch beschichtet wird, wenn also eine beidseitige Beschichtung der Platte erfolgen soll. Ausserdem ist die Art und Weise des Transports auch deshalb von Bedeutung, weil auf diese Weise keine Lackspuren auf Transportbänder, auf denen die Platte aufliegt, gelangen können, beispielsweise durch Bohrungen in einer Platine, wie dies bei bekannten Vorrichtungen der Fall ist. Die Transportbänder können nicht oder nur höchstens ganz geringfügig verschmutzen, was den Reinigungsaufwand erheblich vermindert und damit die Verfügbarkeit der Vorrichtung deutlich vergrössert. Besonders geeignet ist die gesamte Vorrichtung als Bestandteil von ganzen Beschichtungsanlagen, die neben der Plattenzuführung und der eigentlichen Beschichtung auch noch eine Ablüftstation, eine Trockenstation und für den häufig vorkommenden Fall, dass die Platten beidseitig beschichtet werden sollen, auch noch eine Wendestation und gegebenenfalls Rückführmittel umfassen, die die Platten zur Beschichtungsvorrichtung zurückführen, wo dann die zweite Plattenfläche beschichtet werden kann. Selbstverständlich kann die Anlage aber auch seriell aufgebaut sein, d.h. die einseitig beschichtete Platte wird abgelüftet, getrocknet, gewendet und einer zusätzlichen zweiten "in Reihe" geschalteten Beschichtungsvorrichtung zugeführt werden.

## Patentansprüche

1. Beschichtungsvorrichtung für Platten oder plattenförmige Werkstücke, insbesondere für Leiterplatten, die mit einer Beschichtungsmasse, z.B. UV-härtbarem Kunststoff, mit Lack oder dergleichen beschichtet werden, mit ersten Transportmitteln (11) zum Zuführen der zu beschichtenden Platten (P), mit Ausrichtmitteln (22), die die zu beschichtenden Platten so ausrichten, dass ihre Seitenkanten nach dem Ausrichten etwa parallel zur Transportrichtung der Platte (P) angeordnet sind, wobei die Ausrichtmittel (22) zwei etwa parallel zur Transportrichtung der Platten seitlich angeordnete Richtorgane (220,221) umfassen, die im wesentlichen senkrecht zur Transportrichtung aufeinander zu bzw. voneinander weg bewegbar sind, ferner mit einer Vorhangbeschichtungseinrichtung (2), in welcher zweite Transportmittel (21) vorgesehen sind, die die von den ersten Transportmitteln (11) kommenden Platten unter einem in der Vorhangbeschichtungseinrichtung (2) vorgesehenen Vorhanggiesskopf (20) hindurch transportieren, der so angeordnet ist, dass der herabfallende Giessvorhang (200) längs einer quer zur Transportrichtung der Platte (P) verlaufenden Auftrefflinie die Platte (P) beaufschlagt und sie auf diese Weise beschichtet, dadurch gekennzeichnet, dass die Richtorgane (220,221) mit Übergabemitteln (240,241) gekoppelt sind, welchejeweils eine schiefe Ebene definieren, die sich zwischen einer durch die ersten Transportmittel (11) definierten ersten Transportebene und einer durch die zweiten Transportmittel (21) definierten zweiten Transportebene erstreckt, die im wesentlichen parallel zur und oberhalb der ersten Transportebene verläuft, und dass die Übergabemittel (240,241) die Platten (P)von den ersten Transportmitteln (11) abheben und über die schiefe Ebene hinweg an die zweiten Transportmittel (21) übergeben.

2. Beschichtungsvorrichtung nach Anspruch 1, dadurch gekennzeichnet, dass die Richtorgane (220,221) symmetrisch aufeinander zu bzw. voneinander weg bewegbar sind.

3. Beschichtungsvorrichtung nach Anspruch 1 oder 2, dadurch gekennzeichnet, dass die Übergabemittel freilaufende konische Rollen (240,241) umfassen, welche in dem Bereich, in dem die von den ersten Transportmitteln (11) kommenden Platten (P) zwischen die Richtorgane (220,221) einlaufen, so entlang der Richtorgane angeordnet sind, dass sich die Rollenachsen parallel zur Bewegungsrichtung (23) der Richtorgane (220,221) erstrecken, so dass die Richtorgane (220,221) durch ihre Bewegung aufeinander zu die Platten (P)über die konischen Rollen (240,241) hinweg bewegen und an die zweiten Transportmittel (21) übergeben.

4. Beschichtungsvorrichtung nach einem der Ansprüche 1 bis 3, dadurch gekennzeichnet, dass die Richtorgane Richtholme (220,221) umfassen, und dass die zweiten Transportmittel (21) antreibbare Transportbänder (210,211) umfassen, die in Transportrichtung um den jeweiligen Richtholm (220,221) herumlaufend angeordnet sind, wobei die Ebene des jeweiligen Transportbands (210,211) im wesentlichen senkrecht zur Transportebene der Platte (P) verläuft und die Transportbänder (210,211) beim Plattentransport an den Seitenkanten der Platten (P) angreifen.

5. Beschichtungsvorrichtung nach Anspruch 4, dadurch gekennzeichnet, dass die Transportbänder (210,211) eine Längsnut (210a,211a) aufweisen, in der das jeweilige Transportband (210,211) an der zugehörigen Seitenkante der Platte (P) angreift.

6. Beschichtungsvorrichtung nach einem der Ansprüche 1 bis 5, dadurch gekennzeichnet, dass mit den Richtorganen (220,221) Begrenzungsorgane (250,251) zur seitlichen Begrenzung des Giessvorhangs (200) gekoppelt sind, welche gemeinsam mit den Richtorganen (220,221) verstellbar sind

7. Beschichtungsvorrichtung nach Anspruch 6, dadurch gekennzeichnet, dass die Begrenzungsorgane (250,251) zur seitlichen Begrenzung des Giessvorhangs (200) so angeordnet sind, dass der herabfallende Giessvorhang (200) die Platte (P) in einem schmalen Randbereich nahe der Seitenkante der Platte nicht beaufschlagt.

8. Beschichtungsvorrichtung nach Anspruch 6, dadurch gekennzeichnet, dass die Begrenzungsorgane (250,251) zur seitlichen Begrenzung des Giessvorhangs (200) so angeordnet sind, dass der herabfallende Giessvorhang (200) die Platte (P) vollständig über deren gesamte Breite beaufschlagt.

9. Beschichtungsvorrichtung nach Anspruch 8, dadurch gekennzeichnet, dass im Bereich des herabfallenden Giessvorhangs (200) eine Umlenkeinrichtung angeordnet ist, welche die Transportbänder (210,211) in Transportrichtung betrachtet eine kurze Strecke vor dem Giessvorhang (200) von den Seitenkanten der Platte (P) nach aussen weg um die Umlenkeinrichtung herum führt und sie eine kurze Strecke nach dem Giessvorhang (200) wieder zu den Seitenkanten der Platte (P) hin führt.

10. Beschichtungsvorrichtung nach Anspruch 2, dadurch gekennzeichnet, dass die zweiten Transportmittel (21) ein Stützband bzw. zwei Stützbänder (260,261) umfassen, die in Transportrichtung etwa in der von den zweiten Transportmitteln (21) definierten zweiten Transportebene angeordnet sind, und dass die Richtorgane (220,221) symmetrisch in Bezug auf dieses Transportband bzw. diese Transportbänder (260,261) aufeinander zu bzw. voneinander weg verstellbar sind.

## Claims

1. A coating apparatus for boards or board-shaped workpieces, especially for printed circuit boards, that are coated with a coating composition, for example UV-hardenable plastics, with lacquer or the like, comprising first transport means (11) for feeding in the boards (P) to be coated, aligning means (22) that so align the boards to be coated that, after alignment, their side edges are arranged approximately parallel to the direction of transport of the board (P), the aligning means (22) comprising two straightening members (220,221) that are arranged on the sides thereof approximately parallel to the direction of transport of the boards and that can be moved towards one another or away from one another substantially perpendicular to the direction of transport, and a curtain coating device (2) in which are provided second transport means (21) that transport the boards coming from the first transport means (11) under a curtain pouring head (20) provided in the curtain coating device (2), which curtain pouring head (20) is so arranged that the falling pouring curtain (200) falls on the board (P) along a line of contact extending transversely to the direction of transport of the board (P) and thus coats that board (P), wherein the straightening members (220,221) are coupled to transfer means (240,241), each of which defines an inclined plane that extends between a first transport plane that is defined by the first transport means (11) and a second transport plane that is defined by the second transport means (21) and extends substantially parallel to and above the first transport plane, and the transfer means (240,241) lift the boards (P) from the first transport means (11) and transfer them *via* the inclined plane to the second transport means (21).

2. A coating apparatus according to claim 1, wherein the straightening members (220, 221) can be moved towards one another or away from one another symmetrically.

3. A coating apparatus according to either claim 1 or claim 2, wherein the transfer means comprise free-running conical rollers (240,241) that, in the region in which the boards (P) coming from the first transport means (11) enter between the straightening members (220,221), are so arranged along the straightening members that the roller axes extend parallel to the direction of movement (23) of the straightening members (220,221) so that the straightening members (220,221), by their movement towards one another, move the boards (P) *via* the conical rollers (240,241) and transfer them to the second transport means (21).

4. A coating apparatus according to any one of claims 1 to 3, wherein the straightening members comprise straightening bars (220,221) and the second transport means (21) comprise drivable conveyor belts (210,211), each of which is arranged to run round its respective straightening bar (220,221) in the direction of transport, the plane of each conveyor belt (210,211) extending substantially perpendicular to the transport plane of the board (P) and the conveyor belts (210,211) engaging the side edges of the boards (P) when the latter are being transported.

5. A coating apparatus according to claim 4, wherein the conveyor belts (210,211) comprise a longitudinal groove (210a,211a) in which each conveyor belt (210,211) engages the associated side edge of the board (P).

6. A coating apparatus according to any one of claims 1 to 5, wherein there are coupled to the straightening members (220,221) limiting members (250,251) for the lateral delimitation of the pouring curtain (200), which limiting members (250,251) can be displaced together with the straightening members (220,221).

7. A coating apparatus according to claim 6, wherein the limiting members (250,251) for the lateral delimitation of the pouring curtain (200) are so arranged that the falling pouring curtain (200) does not fall on the board (P) in a narrow edge region near the side edge of the board.

8. A coating apparatus according to claim 6, wherein the limiting members (250,251) for the lateral delimitation of the pouring curtain (200) are so arranged that the falling pouring curtain (200) falls on the board (P) over its entire width.

9. A coating apparatus according to claim 8, wherein there is arranged in the region of the falling pouring curtain (200) a deflecting device which, a short distance upstream of the pouring curtain (200), viewed in the direction of transport, guides the conveyor belts (210,211) outwards and away from the side edges of the board (P), around the deflecting device, and, a short distance downstream of the pouring curtain (200), guides them back again to the side edges of the board (P).

10. A coating apparatus according to claim 2, wherein the second transport means (21) comprise a support belt or two support belts (260,261) that are arranged in the direction of transport approximately in the second transport plane defined by the second transport means (21), and the straightening members (220,221) can be displaced towards one another or away from one another symmetrically in relation to that(those) conveyor belt(s) (260,261).

## Revendications

1. Installation de revêtement de cartes ou objets en forme de cartes, en particulier pour cartes à circuit imprimé, que l'on revêt d'une masse de revêtement, par exemple d'un plastique durcissable aux UV, de laque ou analogue, comportant des premiers moyens de transport (11) pour amener les cartes à revêtir (P), des moyens d'orientation (22) qui orientent les cartes à revêtir de façon que leurs arêtes latérales soient, après orientation, disposées à peu près parallèlement à la direction de transport de la carte (P), les moyens d'orientation (22) comportant deux organes d'orientation (220, 221) qui sont disposés latéralement à peu près parallèlement à la direction de transport des cartes et peuvent se déplacer en se rapprochant l'un de l'autre ou en s'écartant l'un de l'autre sensiblement perpendiculairement à la direction de transport, comportant en outre un dispositif (2) de revêtement par rideau, dans lequel sont prévus deux moyens de transport (21) qui transportent les cartes, venant des premiers moyens de transport (11), sous une tête de rideau fluide (20) qui est prévue dans le dispositif (2) de revêtement par rideau et qui est disposée de façon que le rideau fluide descendant (200) tombe sur la carte (P) le long d'une ligne d'incidence orientée perpendiculairement à la direction de transport de la carte (P) et la revête de cette façon, caractérisée par le fait que les organes d'orientation (220, 221) sont couplés avec des moyens de transfert (240, 241) qui définissent chacun un plan oblique qui s'étend entre un premier plan de transport, défini par les premiers moyens de transport (11), et un second plan de transport, défini par les seconds moyens de transport (21) et qui court sensiblement parallèlement au, et au-dessus du, premier plan de transport, et que les moyens de transfert (240, 241) décollent les cartes (P) d'avec les premiers moyens de transport (11) et, par l'intermédiaire du plan oblique, les transfèrent sur les seconds moyens de transport (21).

2. Installation de revêtement selon la revendication 1, caractérisée par le fait que les organes d'orientation (220, 221) peuvent se rapprocher l'un de l'autre ou s'écarter l'un de l'autre symétriquement.

3. Installation de revêtement selon la revendication 1 ou 2, caractérisée par le fait que les moyens de transfert comportent des rouleaux coniques (240, 241) à roulement libre, qui, dans la zone dans laquelle les cartes (P), venant des premiers moyens de transport (11), pénètrent entre les organes d'orientation (220, 21), sont disposés, le long des organes d'orientation, de façon telle que les axes des rouleaux s'étendent parallèlement à la direction du mouvement (23) des organes d'orientation (220, 221) de sorte que, par leur mouvement de rapprochement l'un vers l'autre, les organes d'orientation (220, 221) emmènent les cartes (P) sur les rouleaux coniques (240, 241) et les transfèrent sur les seconds moyens de transport (21).

4. Installation de revêtement selon l'une des revendications 1 à 3, caractérisée par le fait que les organes d'orientation sont constitués de longerons d'orientation (220, 221) et que les seconds moyens de transport (21) comportent des rubans transporteurs qui peuvent être entraînés et qui sont disposés de façon à courir, dans le sens du transport, autour du longeron d'orientation respectif (220, 221), le plan du ruban de transport respectif (210, 211) étant sensiblement perpendiculaire au plan de transport de la carte (P) et les rubans de transport (210, 211) venant, lors du transport des cartes, en contact avec les arêtes latérales des cartes (P).

5. Installation de revêtement selon la revendication 4, caractérisée par le fait que les rubans de transport (210, 211) présentent une rainure longitudinale (210a, 211a) dans laquelle le ruban de transport effectif (210, 211) vient en contact avec l'arête latérale correspondante de la carte (P).

6. Installation de revêtement selon l'une des revendications 1 à 5, caractérisée par le fait qu'aux organes d'orientation (220, 221) sont, pour la limitation latérale du rideau fluide (200), couplés des organes de limitation (250, 251) qui sont réglables en commun avec les organes d'orientation (220, 221).

7. Installation de revêtement selon la revendication 6, caractérisée par le fait que les organes de limitation (250, 251) prévus pour la limitation latérale du rideau fluide (200) sont disposés de façon que le rideau fluide descendant (200) n'interviennent pas sur la carte (P) dans une étroite zone de bordure proche de l'arête latérale de la carte.

8. Installation de revêtement selon la revendication 6, caractérisée par le fait que les organes de limitation (250, 251) prévus pour la limitation latérale du rideau fluide (200) sont disposés de façon que le rideau fluide descendant (200) intervienne complètement sur la carte (P) sur toute la largeur.

9. Installation de revêtement selon la revendication 8, caractérisée par le fait que, dans la zone du rideau fluide descendant (200) est disposé un dispositif de déviation qui, vu selon la direction du transport, peu avant le rideau fluide (200), écarte les rubans transporteurs (210, 211) des arêtes latérales de la carte (P) en les guidant vers l'extérieur, autour du dispositif de déviation, et, peu après le rideau fluide (200), les guide à nouveau pour les amener sur les arêtes latérales de la carte (P).

10. Installation de revêtement selon la revendication 9, caractériséei par le fait que les seconds moyens de transport (21) comportent un tapis d'appui ou deux tapis d'appui (260, 261) qui sont disposés, dans la direction de transport, à peu près dans le second plan de transport, défini par les seconds moyens de transport (21), et que les organes d'orientation (220, 221) sont réglables pour se rapprocher ou s'écarter l'un de l'autre, symétriquement par rapport à ce tapis transporteur ou à ces tapis transporteurs (260, 261).
